# EUROPEAN PATENT APPLICATION

(11) **EP 3 480 857 A1**
(43) Date of publication of application: **08.05.2019**
(21) Application number: 18195753.1
(22) Date of filing: 20.09.2018
(51) Int. Cl.: H01L 31/032, C01B 19/00, C23C 14/06, C23C 14/24, C23C 16/30, C23C 16/46, C23C 14/54

(54) **DEVICE FOR PREPARING MULTI-ELEMENT ALLOY COMPOUND**

(30) Priority: 06.11.2017 CN 201721463168 U
(71) Applicant: Beijing Apollo Ding Rong Solar Technology Co., Ltd., Beijing 100176 (CN)
(72) Inventor: CHEN, Teng, Beijing, 100176 (CN)
(74) Representative: D'Halleweyn, Nele Veerle Trees Gertrudis

(57) **Abstract**

A device for preparing a multi-element alloy compound includes a reactor (1), a low-temperature evaporation zone (2), a high-temperature synthesis zone (3), a sealing device (4) and heating devices (5). The high-temperature synthesis zone (3) and the low-temperature evaporation zone (2) are respectively arranged at two ends of the reactor (1); the heating devices (5) are arranged around the reactor (1) at intervals and are configured to heat the reactor (1) and form a temperature gradient; the reactor (1) has an opening, and the sealing device (4) is configured to be able to seal the opening.

## Description

### Technical Field

The present disclosure relates to, but is not limited to, a device for preparing a multi-element alloy compound.

### Background

As is well-known, CIGS (CuInₓGa₍₁₋ₓ₎Se₂, copper indium gallium selenium) is a kind of thin film solar cell with great potential. At present, the main methods for preparing CIGS in the industry are co-evaporation method and magnetron sputtering method. Based on the high vacuum of these two previous methods, the cost is relatively high from the point of view of equipment and process. Therefore, non-vacuum low-cost technology for preparing CIGS such as printing is continuously promoted by the industry.

At present, there are two main methods for preparing coating slurry or colloid used for non-vacuum printing CIGS. One is that CIGS nano-materials are prepared by chemical synthesis method and further prepared into the slurry. However, the chemically synthesized CIGS has low purity, and the minority carrier lifetime of the prepared CIGS thin film is short, so the current battery using this kind of absorption layer has relatively low efficiency. The other is that four kinds of elemental powders or several binary, ternary compound powders are used to prepare the coating raw materials. It is difficult to control the reaction of this slurry to further form a quaternary compound during the film forming process, and insufficient reaction will cause the components to be mismatched. Moreover, the higher reaction temperature may also cause a large amount of loss of selenium component, resulting in poor quality of the prepared CIGS thin film.

In addition, the preparation of CIGS thin films with gradient band gaps is beneficial to improve the conversion efficiency of the thin film light absorption layer. However, limited to the preparation method of CIGS materials, most of the current CIGS thin films prepared by printing are CIGS thin films with a single fixed component, which is not conducive to the preparation of high efficiency batteries.

### Summary

The following is an overview of the subject matter described in detail herein. This summary is not intended to limit the protection scope of the claims.

In order to solve the above problems, the present disclosure provides a preparation device capable of accurately controlling the composition of the multi-element alloy.

The present disclosure provides a device for preparing a multi-element alloy compound, including a reactor (1), a low-temperature evaporation zone (2), a high-temperature synthesis zone (3), a sealing device (4) and heating devices (5), wherein:
the high-temperature synthesis zone (3) and the low-temperature evaporation zone (2) are respectively arranged at two ends of the reactor (1);
the heating devices (5) are arranged around the reactor (1) at intervals and are configured to heat the reactor (1) and form a temperature gradient;
the reactor has an opening, and the sealing device (4) is configured to be able to seal the opening.

In an exemplary embodiment, the low-temperature evaporation zone (2) may be a quartz boat, a crucible, or a pit formed in the reactor (1).

In an exemplary embodiment, the high-temperature synthesis zone (3) may be a quartz boat, a crucible, or a pit formed in the reactor (1).

In an exemplary embodiment, the high-temperature synthesis zone (3) and the low-temperature evaporation zone (2) may both be pits formed in the reactor (1).

In an exemplary embodiment, the reactor (1) may be an L-shaped reaction tube.

In an exemplary embodiment, the high-temperature synthesis zone (3) may be located at one end of the long side of the L-shaped reaction tube and the low-temperature evaporation zone (2) may be located at one end of the short side of the L-shaped reaction tube (1).

In an exemplary embodiment, the long side of the L-shaped reaction tube may have a length of 1100 mm to 1600 mm, the short side may have a length of 400 mm to 700 mm, and the L-shaped reaction tube may have a diameter of 60 mm to 80 mm.

In an exemplary embodiment, the reactor (1) may be a quartz tube or a ceramic tube.

In an exemplary embodiment, the heating devices (5) may be electric heating coils that surround the outer surface of the reactor (1).

In an exemplary embodiment, the L-shaped reaction tube may be closed at one end, and may be open at the other end and provided with an opening.

In an exemplary embodiment, the opening may be located at one end of the long side of the L-shaped reaction tube.

In an exemplary embodiment, the opening may be a necking.

In an exemplary embodiment, the sealing device (4) may be a sealing bubble.

In an exemplary embodiment, the sealing bubble may have a length of 150 mm to 250 mm and a diameter of 40 mm to 60 mm. In an exemplary embodiment, the quartz boat may be a half pipe having a diameter of 50 mm to 70 mm and a length of 200 mm to 400 mm.

In an exemplary embodiment, the multi-element alloy compound may be a copper indium gallium selenium compound.

In the present disclosure, the term "multi-element alloy compound" is defined as a compound made of a plurality of elementary substances, in which the sublimation temperature of one elementary substance is lower than the melting temperature of a mixture composed of other elementary substances.

By increasing the temperature gradient of the reactor from the low-temperature evaporation zone to the temperature of the high-temperature synthesis zone, a device for preparing a multi-element alloy compound of the present disclosure avoids the vapor obtained after the elemental substance (e.g., selenium) is sublimated into a gaseous state from settling on the tube wall of the reactor, thereby avoiding the loss after the elemental substance is sublimated into the gaseous state and ensuring the sufficient combination reaction of the elemental substance and other elemental substances (e.g., copper, indium and gallium). Since the device for preparing a multi-element alloy compound of the present disclosure can be used to control the content of each element in the multi-element alloy compound, multi-element alloy compounds with different element contents can be prepared, for example, a copper indium gallium selenium compound with different indium to gallium ratios, so that the distribution of elements in the prepared alloy compound is more uniform and the quality is more controllable.

### Brief Description of Drawings

The accompanying drawings are used to provide a further understanding of the technical solution of the present disclosure and form a part of the specification, and serve to explain the technical solution of the present disclosure together with the embodiments of the present disclosure and do not constitute a limitation on the technical solution of the present disclosure.

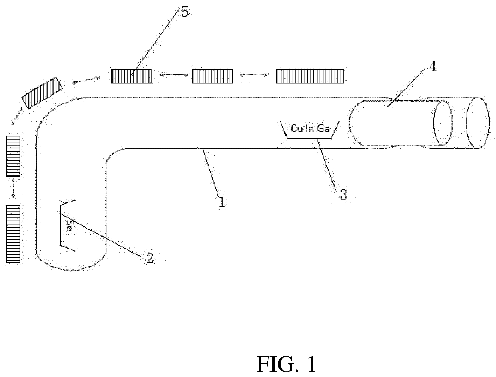

Fig. 1 is a schematic diagram of a device for preparing a copper indium gallium selenium compound according to an embodiment of the present disclosure.

### Detailed Description

The present disclosure will be further described below with reference to the drawing in the specification.

The following is only a preferred embodiment of the present disclosure, but the scope of protection of the present disclosure is not limited thereto. Any changes or substitutions that can be easily thought of by those skilled in the art within the scope of technology disclosed in the present disclosure should be included within the scope of protection scope of the present disclosure. Therefore, the scope of protection of the present disclosure should be based on the scope of protection defined in the claims.

### Example 1

This Example provides a device for preparing a multi-element alloy compound, including a reactor 1, a low-temperature evaporation zone 2, a high-temperature synthesis zone 3, a sealing device 4 and heating devices 5, wherein the high-temperature synthesis zone 3 and the low-temperature evaporation zone 2 are respectively arranged at two ends of the reactor 1; the heating devices 5 are arranged around the reactor 1 at intervals and are configured to heat the reactor 1 and form a temperature gradient; the reactor 1 has an opening, and the sealing device 4 is configured to be able to seal the opening.

The high-temperature synthesis zone 3 may be a quartz boat, a crucible or a pit formed in the reactor 1.

The low-temperature evaporation zone 2 may be a quartz boat, a crucible or a pit formed in the reactor 1.

The reactor 1 may be an L-shaped reaction tube; the reactor 1 may be a quartz tube, a ceramic tube or a tube with certain rigidity prepared from other high temperature resistant materials.

The high-temperature synthesis zone 3 may be located at one end of the long side of the L-shaped reaction tube, and the low-temperature evaporation zone 2 may be located at one end of the short side of the L-shaped reaction tube.

The high-temperature synthesis zone 3 and the low-temperature evaporation zone 2 are respectively arranged at the two ends of the reactor 1, so that the high-temperature synthesis zone 3 and the low-temperature evaporation zone 2 are separated by a set distance, and can be heated to different temperatures. Under the condition that the distance requirement is met, the positions of the high-temperature synthesis zone 3 and the low-temperature evaporation zone 2 can be adjusted as required.

The long side of the L-shaped reaction tube may have a length of 1100 mm to 1600 mm, the short side may have a length of 400 mm to 700 mm, and the L-shaped reaction tube may have a diameter of 60 mm to 80 mm.

The heating devices 5 may be configured to heat different zones of the reactor 1 so that the temperature of each zone can be individually controlled and a temperature gradient can be formed.

The heating devices 5 may be electric heating coils that surround the outer surface of the L-shaped quartz tube or may be arranged near the outer surface of the L-shaped quartz tube as shown in the drawing.

The electric heating coils corresponding to the low-temperature evaporation zone 2 and the high-temperature synthesis zone 3 may have a length of 300 mm, and the electric heating coils located between the electric heating coils corresponding to the low-temperature evaporation zone 2 and the high-temperature synthesis zone 3 may have a length of 200 mm, and may be arranged at interval of 100 mm. The L-shaped reaction tube may be arranged that one end is closed, and the other end is open and provided with an opening, or may be provided with an opening at both ends.

The opening may be located at one end of the long side of the L-shaped reaction tube.

The opening may be a necking, the sealing device 4 may be a sealing bubble, and the sealing bubble may match the shape of the necking so as to be able to seal the necking.

The sealing bubble may have a length of 150 mm to 250 mm, and a diameter of 40 mm to 60 mm, for example, the length may be 200 mm, and the diameter may be 50 mm.

The quartz boat may be a half pipe having a diameter of 50 mm to 70 mm and a length of 200 mm to 400 mm, for example, a half pipe having a diameter of 66 mm and a length of 300 mm.

This Example also provides a method for preparing a multi-element alloy compound. Taking the preparation of the copper indium gallium selenium compound as an example, the method may include the following steps:
S1: providing a vacuum container, wherein the vacuum container includes a high-temperature synthesis zone 3 and a low-temperature evaporation zone 2 which are arranged apart;
S2: placing copper, indium and gallium elementary substances in the high-temperature synthesis zone 3, and placing selenium elementary substance in the low-temperature evaporation zone 2;
S3: heating copper, indium and gallium in the high-temperature synthesis zone 3 to a molten state, and heating selenium in the low-temperature evaporation zone 2 to a gaseous state; the time when selenium in the low-temperature evaporation zone 2 begins to change to gaseous state is not earlier than the time when copper, indium and gallium are melted;
S4: holding the temperature of the high-temperature synthesis zone 3 and the low-temperature evaporation zone 2 to enable copper, indium, gallium and selenium to react;
S5: lowering the temperature of the high-temperature synthesis zone 3 to be not lower than the melting temperature of the copper indium gallium selenium alloy and holding the temperature, and then lowering the temperature of the high-temperature synthesis zone 3 and the low-temperature evaporation zone 2 to 100°C or less;

In the above steps, it is possible to always maintain a positive temperature gradient between the low-temperature evaporation zone 2 and the high-temperature synthesis zone 3, i.e., the temperature of the vacuum container increases in gradient from the low-temperature evaporation zone 2 to the high-temperature synthesis zone 3.

In step S1, a vacuum container is provided, which may be a container made of a high temperature resistant material such as a quartz tube or a ceramic tube and having a certain rigidity. For example, the reactor of this Example is used. Parts of the vacuum container with a certain interval are respectively used as the high-temperature synthesis zone 3 and the low-temperature evaporation zone 2. When the materials are put into the above container, the air pressure within the container is pumped to 10⁻¹ Pa or less to become a vacuum container.

In step S2, Cu, In, Ga and Se elementary substances, with the purity of more than 99.999 % may be used as raw materials, and the mass of each of the elementary substances may be weighed and formulated according to the composition CuIn_{0.7}Ga_{0.3}Se_{2.05}; Se elementary substance may be placed in a quartz boat at one end of the short side of the L-shaped quartz tube; Cu, In and Ga elementary substances may be placed in a quartz boat at one end of the long side of the L-shaped quartz tube, the L-shaped quartz tube is vacuumized to 10⁻²Pa or less, and then the L-shaped quartz tube is sealed and placed in an electric heating furnace. The quartz boat containing the Se elementary substance corresponds to the low-temperature zone corresponding to the low-temperature evaporation zone 2 in the electric heating furnace. The quartz boat containing the Cu, In and Ga elementary substances corresponds to the high-temperature zone corresponding to the high-temperature synthesis zone 3 in the electric heating furnace. In addition to the L-shaped quartz tube, the reactor of the device for preparing a multi-element alloy compound of this Example may also be used to form a vacuum container, and the reactor may be vacuumized to other pressures of 10⁻¹ Pa or less, for example, 10⁻¹Pa, 10⁻²Pa, 10⁻³Pa, or 10⁻⁴Pa. It is also possible to use other high temperature resistant containers instead of quartz boat to hold materials, for example, a crucible to hold materials. If there is a pit in the high-temperature synthesis zone 3 and the low-temperature evaporation zone 2 of the container, the materials can be directly placed in the pit without using other containers to hold the materials. Other heating devices may also be used to heat the L-shaped quartz tube, such as the heating devices 5 of the device for preparing a multi-element alloy compound provided in this Example.

The components of the copper indium gallium selenium compound described above are not limited to the components of the copper indium gallium selenium compound prepared in this Example. For example, the copper indium gallium selenium compounds of the following composition may also be prepared: CuIn_{0.85}Ga_{0.15}Se_{2.05}, CuIn_{0.9}Ga_{0.1}Se₂, CuIn_{0.8}Ga_{0.2}Se₂, CuIn_{0.75}Ga_{0.25}Se₂. In the preparation process of the above copper indium gallium selenium compounds, the mass of copper, indium and gallium elementary substances may be calculated according to that the sum of the mole parts of indium and gallium is substantially equal to the mole part of copper during weighing. For example, the mole part ratio of copper, indium and gallium can be substantially equal to the atomic number ratio of copper, indium and gallium in the compound to be prepared, while the mole part of selenium can be calculated to be greater than twice the mole part of copper. For example, the mole part ratio of selenium to copper can be slightly larger than the atomic number ratio of selenium to copper in the compound to be prepared. For example, the mole part of selenium may be 2.1 times, 2.2 times, 2.3 times, 2.4 times or 2.5 times that of copper. Excess selenium is placed in the low-temperature evaporation zone 2, so that during the whole reaction process, since selenium is excessive, the reaction can always be carried out in an atmosphere of selenium vapor.

In step S3, a linear temperature gradient range from low temperature to high temperature may be formed by adjusting the temperature control power between the high-temperature synthesis zone 3 and the low-temperature evaporation zone 2. The high-temperature synthesis zone 3 may be set to raise the temperature to 1100-1150°C for 85 min to 90 min. When the high-temperature synthesis zone 3 starts to heat up for 55 min to 60 min, the temperature of the high-temperature synthesis zone 3 may raise to 700°C-750°C. At this time, the heating up of the low-temperature evaporation zone 2 can be started, and the heating up of the low-temperature evaporation zone 2 to 550°C -600°C can be set for 55 min to 60 min.

For example, the heating power of the heating devices corresponding to the respective zones between the high-temperature synthesis zone 3 and the low-temperature evaporation zone 2 can be individually adjusted so that a temperature gradient range from low temperature to high temperature can be formed from the low-temperature evaporation zone 2 to the high-temperature synthesis zone 3, for example, a linear temperature gradient range may be formed. The power of the heating devices can be set to raise the temperature of the high-temperature synthesis zone 3 to 1100-1150°C for 85 min to 90 min. The power of the heating devices can be set to raise the temperature of the low-temperature evaporation zone 2 to 550-600°C for 55 min to 60 min. In step S4, the low-temperature evaporation zone 2 is maintained for 6 hours after reaching the highest temperature. The time for holding temperature can be calculated according to the quantity of materials, reaction type and other conditions, so as to ensure that the copper, indium, gallium and selenium can be completely reacted. For example, both the high-temperature synthesis zone 3 and the low-temperature evaporation zone 2 are held for 6h after the low-temperature evaporation zone 2 reaches the highest temperature.

The fact that the time when selenium in the low-temperature evaporation zone 2 begins to change to the gaseous state is not earlier than the time when copper indium gallium is melted, may be that the time when selenium in the low-temperature evaporation zone 2 begins to change to the gaseous state is not earlier than the time when copper indium gallium is completely melted.

In step S5, the temperature of the high-temperature synthesis zone 3 is lowered to be not lower than the melting temperature of the copper indium gallium selenium alloy and holding temperature is carried out, the purpose of which is to ensure that the alloy elements are in a positive saturation state and do not affect the inverse reaction of CIGS. The high-temperature synthesis zone 3 may be set to cool down to 950-1000°C for 15 min, then held for 1.5 h to 2 h, and then all heating devices are turned off to cool the high-temperature synthesis zone 3 and the low-temperature evaporation zone 2 to 100°C or less. A CIGS quaternary compound is obtained in the quartz boat of the high-temperature synthesis zone 3, and the composition of the synthesized CIGS compound is CuIn_{0.7}Ga_{0.3}Se₂. In this Example, the mass of each of the elementary substances is weighed according to the composition CuIn_{0.7}Ga_{0.3}Se_{2.05} in step S2, and the composition of the obtained CIGS compound is CuIn_{0.7}Ga_{0.3}Se₂, that is, to obtain the compound CuIn_{0.7}Ga_{0.3}Se₂, the molar ratio of elementary substances to be weighed can be calculated according to the atomic ratio of elements in CuIn_{0.7}Ga_{0.3}Se_{2.05}.

In order to ensure that selenium vapor does not condense on the inner wall of the quartz tube during transportation, there may be a positive temperature gradient between the low-temperature evaporation zone 2 and the high-temperature synthesis zone 3. In order to ensure the stability of selenium vapor transportation rate, it may be controlled that there is a linear temperature gradient between the low-temperature evaporation zone 2 and the high-temperature synthesis zone 3 of the entire quartz tube.

In the preparation method of the copper indium gallium selenium compound of this Example, copper, indium and gallium are firstly heated to a molten state, so that copper, indium and gallium are reacted firstly, and then selenium is heated and sublimated into a gaseous state, so that a selenium atmosphere is formed in a vacuum container, thereby selenizing the copper, indium and gallium. In order to enable the copper, indium and gallium to be evenly selenized, the present disclosure can ensure that the time for the copper, indium and gallium to be completely melted is no later than the time for selenium to start sublimation. In addition, in order to ensure that selenium vapor can be transported to the high-temperature synthesis zone 3 at a stable rate, there can always be a positive temperature gradient from the low-temperature evaporation zone 2 to the high-temperature synthesis zone 3.

### Example 2

A method for preparing a copper indium gallium selenium compound may include the following steps:
S1: providing a vacuum container, wherein the vacuum container includes a high-temperature synthesis zone 3 and a low-temperature evaporation zone 2 which are arranged apart;
S2: placing copper, indium and gallium elementary substances in the high-temperature synthesis zone 3, and placing selenium elementary substance in the low-temperature evaporation zone 2;
S3: heating copper, indium and gallium in the high-temperature synthesis zone 3 to a molten state, and heating selenium in the low-temperature evaporation zone 2 to a gaseous state; the time when selenium in the low-temperature evaporation zone 2 begins to change to gaseous state is not earlier than the time when copper, indium and gallium are melted;
S4: holding the temperature of the high-temperature synthesis zone 3 and the low-temperature evaporation zone 2 to enable copper, indium, gallium and selenium to react;
S5: lowering the temperature of the high-temperature synthesis zone 3 to be not lower than the melting temperature of the copper indium gallium selenium alloy and holding temperature, and then lowering the temperature of the high-temperature synthesis zone 3 and the low-temperature evaporation zone 2 to 100°C or less.

In the above steps, it is possible to always maintain a positive temperature gradient between the low-temperature evaporation zone 2 and the high-temperature synthesis zone 3.

In step S1, a vacuum container is provided, which may be an L-shaped quartz tube. The vacuum container includes a high-temperature synthesis zone 3 and a low-temperature evaporation zone 2. Parts of the vacuum container with certain intervals are respectively used as a high-temperature synthesis zone 3 and a low-temperature evaporation zone 2. The two ends of the L-shaped quartz tube are respectively a high-temperature synthesis zone 3 and a low-temperature evaporation zone 2. The high-temperature synthesis zone 3 is provided with a quartz boat containing copper, indium and selenium elementary substances, and the low-temperature evaporation zone 2 is provided with a quartz boat containing selenium elementary substance.

In step S2, Cu, In, Ga and Se elementary substances with purity greater than 99.999 % may be used as raw materials, and the mass of each of the elementary substances may be weighed and formulated according to the composition CuIn_{0.8}Ga_{0.2}Se_{2.05}, the Se elementary substance is placed in a quartz boat at one end of the short side of the L-shaped quartz tube, the Cu, In and Ga elementary substances are placed in a quartz boat at one end of the long side of the L-shaped quartz tube, the quartz tube may be vacuumized to 10⁻³Pa or less, then the L-shaped quartz tube is sealed and placed in an electric heating furnace. The quartz boat containing the Se elementary substance may correspond to the low-temperature zone corresponding to the low-temperature evaporation zone 2 in the electric heating furnace. The quartz boat containing the Cu, In and Ga elementary substances may correspond to the high-temperature zone corresponding to the high-temperature synthesis zone 3 in the electric heating furnace.

In step S3, a linear temperature gradient range from low temperature to high temperature may be formed by adjusting the temperature control power between the high-temperature synthesis zone and the low temperature synthesis zone. The high-temperature synthesis zone 3 may be set to heat up to 1125°C for 88 min. When the high-temperature synthesis zone 3 starts to heat up for 55 min, the temperature of the high-temperature synthesis zone 3 may rise to 725°C, at this time, the temperature of the low-temperature evaporation zone 2 may be started to heat up, and the low-temperature evaporation zone 2 may be set to heat up to 575°C for 56 min.

In step S4, after the low-temperature evaporation zone 2 reaches 575°C, the temperature of the high-temperature synthesis zone and the temperature of the low-temperature evaporation zone may be held for 6 hours.

In step S5, the high-temperature synthesis zone may be set to be cooled to 960°C for 15 min, then held for 2 h, then all heating devices are turned off to cool the high-temperature synthesis zone and the low-temperature evaporation zone to 100°C or less, a CIGS quaternary compound is obtained in the quartz boat of the high-temperature synthesis zone, and the composition of the synthesized CIGS compound is CuIn_{0.8}Ga_{0.2}Se₂. In this Example, the mass of each of the elementary substances is weighed according to the composition CuIn_{0.8}Ga_{0.2}Se_{2.05} in step S2, and the composition of the obtained CIGS compound is CuIn_{0.8}Ga_{0.2}Se₂, that is, to obtain the compound CuIn_{0.8}Ga_{0.2}Se₂, the molar ratio of elementary substances to be weighed can be calculated according to the atomic ratio of elements in CuIn_{0.8}Ga_{0.2}Se_{2.05}.

In order to ensure that selenium vapor does not condense on the inner wall of the quartz tube during transportation, there may be a positive temperature gradient between the low-temperature evaporation zone 2 and the high-temperature synthesis zone 3. In order to ensure the stability of selenium vapor transportation rate, it may be controlled that there is a linear temperature gradient between the low-temperature evaporation zone 2 and the high-temperature synthesis zone 3 of the entire quartz tube.

Since the preparation method of the copper indium gallium selenium alloy of the present disclosure can accurately control the composition of the copper indium gallium selenium alloy during the preparation process, the composition of the copper indium gallium selenium of each absorption layer can be controlled during the preparation of the light absorption layer with progressive band gap, and the band gap width of each absorption layer can also be controlled, so that the preparation of the light absorption layer with progressive band gap by the printing method can be realized.

This disclosure is illustrative of the principles of examples of the present disclosure and is not intended to limit the present disclosure in any form or substance, or to limit the application to particular embodiments. It will be apparent to those skilled in the art that variations, changes, modifications, evolutions, and the like may be made to the elements, methods, and systems of the technical solutions of the examples of the present disclosure without departing from the principles, spirit, and scope of the examples, and technical solutions of the present disclosure. Embodiments of such variations, changes, modifications, and evolutions are all included within equivalent examples of the present disclosure. Although the examples of the present disclosure may be embodied in many different forms, what is described in detail herein are merely some embodiments of the invention. Furthermore, examples of the present disclosure include any possible combination of some or all of the various embodiments described herein. All patents, patent applications, and other cited materials mentioned in the present disclosure or anywhere in any cited patent, cited patent application, or other cited material are hereby incorporated by reference in their entirety.

The above disclosure is intended to be illustrative and not exhaustive. Many variations and alternatives will be suggested to those skilled in the art. The term "include" means "include, but not limited to". A description of alternative embodiments of the present disclosure has been completed herein. Those skilled in the art will recognize other equivalent changes to the embodiments described herein.

## Claims

1. A device for preparing a multi-element alloy compound, comprising a reactor (1), a low-temperature evaporation zone (2), a high-temperature synthesis zone (3), a sealing device (4) and heating devices (5), wherein:
the high-temperature synthesis zone (3) and the low-temperature evaporation zone (2) are respectively arranged at two ends of the reactor (1);
the heating devices (5) are arranged around the reactor (1) at intervals and are configured to heat the reactor (1) and form a temperature gradient;
the reactor (1) has an opening, and the sealing device (4) is configured to seal the opening.

2. The device for preparing a multi-element alloy compound according to claim 1, wherein the low-temperature evaporation zone (2) is a quartz boat, a crucible, or a pit formed in the reactor (1).

3. The device for preparing a multi-element alloy compound according to claim 1, wherein the high-temperature synthesis zone (3) is a quartz boat, a crucible, or a pit formed in the reactor (1).

4. The device for preparing a multi-element alloy compound according to claim 1, wherein the reactor (1) is an L-shaped reaction tube.

5. The device for preparing a multi-element alloy compound according to claim 4, wherein the high-temperature synthesis zone (3) is located at one end of the long side of the L-shaped reaction tube and the low-temperature evaporation zone (2) is located at one end of the short side of the L-shaped reaction tube.

6. The device for preparing a multi-element alloy compound according to claim 5, wherein the long side of the L-shaped reaction tube has a length of 1100 mm to 1600 mm, the short side has a length of 400 mm to 700 mm, and the L-shaped reaction tube has a diameter of 60 mm to 80 mm.

7. The device for preparing a multi-element alloy compound according to any one of claims 1-6, wherein the reactor (1) is a quartz tube or a ceramic tube.

8. The device for preparing a multi-element alloy compound according to any one of claims 1-6, wherein the heating devices (5) are electric heating coils that surround the outer surface of the reactor (1) and are arranged at intervals.

9. The device for preparing a multi-element alloy compound according to claim 4, wherein one end of the L-shaped reaction tube is closed, and the other end is open and provided with an opening.

10. The device for preparing a multi-element alloy compound according to claim 9, wherein the opening is located at one end of the long side of the L-shaped reaction tube.

11. The device for preparing a multi-element alloy compound according to any one of claims 1-6, 9 and 10, wherein the opening is a necking .

12. The device for preparing a multi-element alloy compound according to any one of claims 1-6, 9 and 10, wherein the sealing device (4) is a sealing bubble.

13. The device for preparing a multi-element alloy compound according to claim 12, wherein the sealing bubble has a length of 150 mm to 250 mm and a diameter of 40 mm to 60 mm.

14. The device for preparing a multi-element alloy compound according to claim 2 or 3, wherein the quartz boat is a half pipe having a diameter of 50 mm to 70 mm and a length of 200 mm to 400 mm.

15. The device for preparing a multi-element alloy compound according to any one of claims 1-6, 9 and 10, wherein the multi-element alloy compound is a copper indium gallium selenium compound.
